(19) Europäisches Patentamt
European Patent Office
Office européen des brevets

(11) **EP 4 253 969 B1**

(12) **EUROPÄISCHE PATENTSCHRIFT**

(45) Veröffentlichungstag und Bekanntmachung des Hinweises auf die Patenterteilung:
**31.07.2024 Patentblatt 2024/31**

(21) Anmeldenummer: **23152385.3**

(22) Anmeldetag: **19.01.2023**

(51) Internationale Patentklassifikation (IPC):
**G01R 15/18** *(2006.01)* **G01R 19/00** *(2006.01)*
**G01R 19/02** *(2006.01)* **G01R 19/165** *(2006.01)*

(52) Gemeinsame Patentklassifikation (CPC):
**G01R 15/183; G01R 19/0092; G01R 19/1659;**
G01R 19/0053; G01R 19/02

(54) **VERFAHREN ZUR SÄTTIGUNGSDETEKTION EINES STROMWANDLERS**

METHOD FOR DETECTING SATURATION OF A CURRENT TRANSFORMER

PROCÉDÉ DE DÉTECTION DE SATURATION D'UN TRANSFORMATEUR DE COURANT

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **01.04.2022 AT 502132022**

(43) Veröffentlichungstag der Anmeldung:
**04.10.2023 Patentblatt 2023/40**

(73) Patentinhaber: **Sprecher Automation GmbH 4020 Linz (AT)**

(72) Erfinder: **Sult, Tilmann 12527 Berliin (DE)**

(74) Vertreter: **Hübscher & Partner Patentanwälte GmbH**
**Spittelwiese 4**
**4020 Linz (AT)**

(56) Entgegenhaltungen:
**EP-A2- 0 882 990      WO-A1-03/065533**
**WO-A1-2008/145694      US-A1- 2005 094 344**

- **ALI AKBAR ABDOOS: "Detection of current transformer saturation based on variational mode decomposition analysis", IET GENERATION,TRANSMISSION&DISTRIBUTION, IET, UK, vol. 10, no. 11, 1 August 2016 (2016-08-01), pages 2658 - 2669, XP006102817, ISSN: 1751-8687, DOI: 10.1049/IET-GTD.2015.0906**

**Beschreibung**

Die Erfindung bezieht sich auf ein Verfahren zur Sättigungsdetektion eines Stromwandlers wobei das gewandelte Stromsignal zeitdiskret abgetastet, von einer Recheneinheit der Abtastwert je Zeitschritt in einem Messwertspeicher abgelegt, anhand mehrerer Abtastwerte die Modellparameter eines ein Wechsel- und ein exponentielles Gleichstromglied aufweisenden Signalmodells bestimmt und die Modellparameter in einem Parameterspeicher abgelegt werden.

Wird ein Stromwandler mit zu hohem Eingangsstrom gespeist, geht das Material des Wandlerkerns in Sättigung und das Signal kann nicht mehr verzerrungsfrei in ein ausgehendes Stromsignal gewandelt werden. Aus dem Stand der Technik sind Verfahren bekannt, um eine solche Sättigung zu detektieren. Die WO2008145694A1 zeigt ein solches Verfahren, bei dem ein gewandeltes Stromsignal erfasst und überprüft wird, ob eine Störung durch Sättigung vorliegt. Ab Beginn der Sättigung werden aus den vorigen, ungestörten Messwerten Rechenparameter bestimmt und mit diesen ein ungesättigtes Extrapolationssignalmodell gebildet.

Nachteilig am Stand der Technik ist allerdings, dass zur Detektion einer Sättigung für jeden Zeitschritt zusätzlich ein aus einem zuvor berechneten, ungestörten Signalmodell extrapolierter, korrigierter Abtastwert errechnet werden muss, dessen Differenz mit dem momentanen Abtastwert mit einem weiteren Schwellenwert verglichen wird.

Die EP0882990A2 schlägt ein Verfahren vor, bei dem ein Stromsignalverlauf abgetastet und aus den Abtastwerten auf Basis einer Mustererkennung der Anfang und das Ende der Sättigung detektiert wird, anschließend die Abtastwerte zwischen Anfang und Ende der Sättigung verworfen werden und aus Abtastwerten, die vor Sättigungsanfang aufgenommen wurden, ein Abbild des ungesättigten Stromsignalverlaufs rekonstruiert wird.

Die WO 03/065533 A1 offenbart ein Verfahren zur Erkennung eines gesättigten Stromverlaufs eines Stromwandlers. Der Sekundärstrom wird abgetastet und in digitale Messwerte umgesetzt. Zwei Kriterien müssen zur Sättigungserkennung erfüllt sein: i.) Die Differenz zwischen gemessenem und aufgrund eines Modells erwartetem Messwert ist größer als ein bestimmter Schwellenwert; ii.) der magnetische Fluss ist größer oder kleiner als zwei jeweils bestimmten Schwellenwerte.

Der Erfindung liegt somit die Aufgabe zugrunde, trotz geringerem Ressourcenaufwand im Normalbetrieb die Fehleranfälligkeit einer Stromwandlersättigungsdetektion zu verringern.

Die Erfindung löst die gestellte Aufgabe dadurch, dass in aufeinanderfolgenden Zeitschritten als Rechenparameter eine laufende Summe der Abtastwerte, der Effektivwert des Wechselstromglieds mit seinem Mittelwert und seiner Varianz, die Basis des exponentiellen Gleichstromglieds mit seinem Mittelwert und der Koeffizient des Gleichstromglieds mit seiner laufenden Summe bestimmt und ein Sättigungssignal ausgegeben wird, wenn der Mittelwert der Basis des exponentiellen Gleichstromglieds außerhalb eines Basisnormbereichs liegt, der Mittelwert des Effektivwerts über einem ersten Nennstromgrenzwert liegt, die Varianz des Effektivwerts oberhalb einer Mindestvarianz liegt und das Vorzeichen des Abtastwerts mit dem Vorzeichen der laufenden Summe der Abtastwerte und der laufenden Summe der Koeffizienten des Gleichstromglieds übereinstimmt. Zufolge der erfindungsgemäßen Maßnahmen kann durch den Vergleich einfach zu bestimmender Rechenparameter mit entsprechenden Vorgabewerten rasch und zuverlässig der Eintritt einer Sättigung im Material des Stromwandlerkerns detektiert werden, ohne dass das abgetastete Stromsignal ressourcenintensiv extrapoliert werden müsste. Im Folgenden wird von einem üblichen Stromnetz mit einer Netzfrequenz von 50Hz ausgegangen, wobei das erfindungsgemäße Verfahren auch für andere Stromnetze bzw. Einsatzbereiche von Stromwandlern Anwendung finden kann. Die Abtastung des Stromsignals kann mit einer Frequenz von 1kHz erfolgen. Um den Ressourcenaufwand weiter zu reduzieren, können die Modellparameter nach einer vorgegebenen Anzahl von Zeitschritten aus dem Parameterspeicher gelöscht oder überschrieben werden. Darüber hinaus können auch die Rechenparameter für jeden Zeitschritt im Parameterspeicher abgelegt werden, sodass beispielsweise laufende Summen oder Mittelwerte effizient nur unter Berücksichtigung des letzten Zeitschritts ermittelt werden können. Als Signalmodell kann beispielsweise

$$x_n = A\,sin(n\Delta) + B\,cos(n\Delta) + C\alpha^n$$

verwendet werden, wobei $A\,sin(n\Delta) + B\,cos(n\Delta)$ das Wechselstromglied und $C\alpha^n$ das exponentielle Gleichstromglied bildet. Die Modellparameter sind somit im Wechselstromglied die Koeffizienten A und B und im Gleichstromglied der Koeffizient C und die Basis $\alpha$. $n$ bezeichnet den Zeitschritt der Abtastung und $\Delta$ ist die Abtastschrittweite in Grad. Der Effektivwert des Wechselstromglieds ist durch $x_{eff} = \sqrt{\dfrac{A^2+B^2}{2}}$ gegeben.

Versuche haben gezeigt, dass die Mindestvarianz für die Ausgabe eines Sättigungssignals beim 8,6-fachen der Varianz des Effektivwerts der vorangegangenen Zeitschritte liegen kann.

Empirische Untersuchungen haben gezeigt, dass der Basisnormbereich insbesondere für übliche Stromnetze zwischen 0,95 und 0,999, vorzugsweise 0,9 und 0,999 liegen kann. Dies entspricht einer Zeitkonstanten von ca. 20ms bis ca. 1s bzw. 9,5ms bis 1s, was typischen Netzkonstellationen einschließlich einem Puffer entspricht. Der erste Nennstromgrenzwert kann gemäß dieser Untersuchungen dem vierfachen des Nennstroms des Stromwandlers entsprechen. Die Mindestvarianz kann gemäß dieser Untersuchungen dem 8,6 - fachen der Varianz des Effektivwerts des Wechselstromglieds entsprechen.

Um den Ressourcenaufwand im laufenden Normalbetrieb weiter zu senken, können die Abtastwerte von der Recheneinheit auf eine transiente Signaländerung überwacht werden und die Modell- und Rechenparameter nur nach Eintritt einer transienten Signaländerung bestimmt werden. Diese Maßnahme geht auf die Überlegung zurück, dass eine Sättigung des Wandlerkernmaterials zu einem als Sättigungsstörung bezeichneten transienten Vorgang im ausgangseitigen Stromsignal führt. Für die Überwachung der Abtastwerte auf eine transiente Signaländerung kann beispielsweise ein Sprungdetektor eingesetzt werden.

Um trotz des Eintritts einer Sättigung im Wandlerkern mit geringem zusätzlichen Aufwand korrekte ausgangseitige Stromsignale ermitteln zu können, wird vorgeschlagen, dass ab Ausgabe des Sättigungssignals aus vor dem Beginn der Sättigung abgelegten Modellparametern jene Modellparameter ausgewählt werden, deren Effektivwert innerhalb einer Nennvarianz vom gemittelten Effektivwert des jeweiligen Zeitschritts liegt, von diesen Modellparametern der Mittelwert der Basis des Gleichstromglieds bestimmt und aus den ausgewählten, auf einen Zeitschritt bezogenen Modellparametern unter Verwendung des Mittelwerts der Basis des Gleichstromglieds ein ungesättigtes Extrapolationssignalmodell bestimmt wird, mit Hilfe dessen korrigierte Abtastwerte ausgegeben werden. Aufgrund dessen können die bereits ermittelten Modellparameter weiterverwendet werden und müssen lediglich auf ihre Plausibilität geprüft werden. Sofern neben den Modellparametern auch die Rechenparameter im Parameterspeicher abgelegt werden, kann auch auf den bereits berechneten gemittelten Effektivwert des Wechselstromglieds des Signalmodells zurückgegriffen werden. Um trotz der zeitlichen Änderung des Stromsignals die ausgewählten Modellparameter zur Verbesserung der Modellqualität mitteln zu können, müssen die Modellparameter unterschiedlicher Zeitschritte auf einen Zeitschritt bezogen werden. Dies kann beispielsweise durch folgendes Verschieben um einen Zeitschritt erfolgen:

$$A' = A \cos(\Delta) - B \sin(\Delta)$$

$$B' = A \sin(\Delta) + B \cos(\Delta)$$

$$C' = C\alpha$$

Da sich $\alpha$, also die Basis des exponentiellen Gleichstromglieds, bei jedem Zeitschritt aufgrund von Messungenauigkeiten bzw. Abweichungen zum Signalmodell ändert, wird daher der Mittelwert von $\alpha$ für obige

Bestimmung von C' verwendet. Wurden alle Modellparameter unterschiedlicher Zeitschritte auf einen gemeinsamen Zeitschritt bezogen, kann für jeden der Modellparameter ein Mittelwert gebildet werden, wobei diese Mittelwerte in ein dem Signalmodell entsprechenden ungesättigten Extrapolationssignalmodell eingesetzt werden. Empirische Untersuchungen haben gezeigt, dass die Nennvarianz dem Doppelten, vorzugsweise dem Fünffachen der Wurzel der Varianz des Effektivwerts entspricht. Für die Auswahl und Mittelwertbildung der Modellparameter für das Extrapolationssignalmodell können die abgespeicherten Modellparameter und gegebenenfalls Rechenparameter der sechzehn Zeitschritte vor Ausgabe des Sättigungssignals herangezogen werden.

Aufgrund der Störungsanfälligkeit des Extrapolationssignalmodells können nur dann korrigierte Abtastwerte ausgegeben werden, wenn der berechnete Koeffizient des Gleichstromglieds des Extrapolationssignalmodells innerhalb eines Effektivnormbereichs liegt, der Effektivwert des Extrapolationssignalmodells größer als ein zweiter Nennstromgrenzwert ist, der korrigierte Abtastwerte größer oder gleich einem korrigierten Abtastgrenzwert ist und das Vorzeichen des korrigierten Abtastwerts dem Vorzeichen der laufenden Summe des Koeffizienten des Gleichstromglieds entspricht. Obwohl die zuvor festgelegten Vorgabewerte für die Detektion einer Sättigung ausreichen, können diese dennoch zu einem Extrapolationssignalmodell führen, das keine zuverlässigen korrigierten Abtastwerte liefert. Die Ausgabe korrigierter Abtastwerte kann daher unterdrückt werden, wenn das Extrapolationssignalmodell nicht empirisch bestimmten Vorgabewerten entspricht. So kann der Effektivnormbereich beispielsweise 5% bis 150% des gemittelten Effektivwerts des Wechselstromglieds des Extrapolationsmodells entsprechen. Der zweite Nennstromgrenzwert kann beispielsweise dem 3,6 - fachen des Nennstroms des Stromwandlers entsprechen. Der Abtastgrenzwert kann beispielsweise dem 0,9 - fachen des nicht korrigierten Abtastwerts des aktuellen Zeitschritts entsprechen. In einer bevorzugten Ausführungsform des erfindungsgemäßen Verfahrens wird überprüft, wie stark die Modellparameter mit den Abtastwerten korrelieren. Dazu werden aus den Modellparametern nach dem Beginn der Sättigung weitere Modellparameter für Zeitschritte vor der Sättigung bestimmt und diese weiteren Modellparameter mit den Abtastwerten des jeweiligen Zeitschritts verglichen. Um mit den Modellparametern eines Zeitschritts die Modellparameter des diesem Zeitschritt vorhergehenden Zeitschritts zu bestimmen, kann wie folgt umgeformt werden:

$$A'' = A \cos(\Delta) + B \sin(\Delta)$$

$$B'' = -A \sin(\Delta) + B \cos(\Delta)$$

$$C'' = \frac{C}{\propto}$$

Der vorherige modellierte Abtastwert ergibt sich dann zu

$$x'' = B'' + C''$$

Nun werden die absoluten Differenzen zwischen vorherigen modellierten Abtastwerten und den Abtastwerten des jeweiligen Zeitschritts bestimmt und gemittelt. Wenn dieser Mittelwert der Differenzen um weniger als das 0,2-fache des Effektivwerts vom Effektivwert abweicht, korrelieren die Modellparameter ausreichend stark mit den Abtastwerten. Ist dies nicht der Fall, wird so verfahren, als ob die Varianz des Effektivwerts nicht oberhalb der Mindestvarianz liegt und keine Sättigung vorliegen würde.

Da eine Sättigung des Wandlerkerns nur im Bereich der Maximalwerte der Amplituden des Stromsignals auftritt, kann früher auf tatsächliche Abtastwerte zurückgegriffen werden, wenn eine vorgegebene Zeitspanne nach dem Vorzeichenwechsel des korrigierten Abtastwerts das Sättigungssignal unterdrückt wird. Für übliche Stromnetze mit einer Netzfrequenz von 50Hz kann die vorgegebene Zeitspanne 2ms betragen. Das Sättigungssignal kann dabei so lange unterdrückt werden, solange bei positiver laufender Summe des Koeffizienten des Gleichstromglieds des Extrapolationssignalmodells der korrigierte Abtastwert kleiner wird und bei negativer laufender Summe des Koeffizienten des Gleichstromglieds des Extrapolationssignalmodells der korrigierte Abtastwert größer wird. Da es bei der Bestimmung des Zeitpunkts des Vorzeichenwechsels aufgrund etwaiger Unsicherheiten des Modells zu Ungenauigkeiten kommen kann, kann anhand der vorgegebenen Zeitspanne ermöglicht werden, dass das Sättigungssignal ausreichend lange unterdrückt wird. Weiters dient die vorgegebene Zeitspanne dazu, dass Nichtlinearitäten der Magnetisierung des Stromwandlers, die zum Zeitpunkt des Wechsels des Vorzeichens des korrigierten Abtastwertes auftreten, nicht berücksichtigt werden.

Um eine wiederkehrende Sättigung zu detektieren, kann bei Ausgabe des Sättigungssignals die Normdifferenz aus dem korrigierten Abtastwert und dem Abtastwert bestimmt und für nachfolgende Zeitschritte aus dem betragsmäßigen Verhältnis aus der um die Normdifferenz erhöhten Differenz aus dem korrigierten Abtastwert und dem Abtastwert des Zeitschritts zum Mittelwert des Effektivwerts des Signalmodells eine Kenngröße ermittelt und das Sättigungssignal ausgegeben werden, wenn die Kenngröße eine Kenngrößenschwelle übersteigt.

Ist die Kenngröße unterhalb der Kenngrößenschwelle, so kann die Normdifferenz aus dem korrigierten Abtastwert und dem nicht korrigierten Abtastwert des aktuellen Zeitschritts neu bestimmt werden. Die Kenngrößenschwelle kann 0,03 betragen.

In der Zeichnung ist der Erfindungsgegenstand beispielsweise dargestellt. Es zeigen

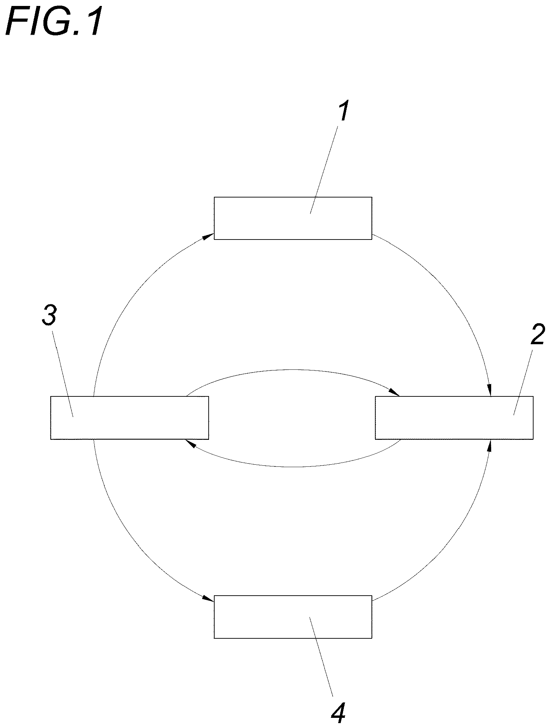

Fig. 1 ein schematisches Zustandsdiagramm zur Erläuterung des erfindungsgemäßen Verfahrens und

Fig. 2 den ausgangseitigen Stromverlauf anhand der erfassten, nicht korrigierten Abtastwerte, die ausgegebenen, korrigierten Abtastwerte und den aktuellen Zustand entsprechend dem Zustandsdiagramm der Fig. 1.

Ein erfindungsgemäßes Verfahren beginnt zunächst im Zustand keiner Sättigung 1, in dem laufend das gewandelte Stromsignal eines Stromwandlers zeitdiskret abgetastet wird. Sobald eine transiente Signaländerung detektiert wird, wechselt das Verfahren in den Zustand eines transienten Vorgangs 2 in dem eine vorgegebene Anzahl von Abtastwerten des gewandelten Stromsignals in einem Messwertspeicher abgelegt wird. Bei einem verwendeten Signalmodell mit vier Modellparametern kann die vorgegebene Anzahl vier betragen, damit die Modellparameter eindeutig bestimmt werden können.

Liegen alle erforderlichen Abtastwerte im Messwertspeicher vor, erfolgt im Zustand der Sättigungsdetektion 3 die Bestimmung von Rechenparametern, nämlich der laufenden Summe der Abtastwerte, dem Effektivwert des Wechselstromglieds mit seinem Mittelwert und seiner Varianz, der Basis des exponentiellen Gleichstromglieds mit seinem Mittelwert und dem Koeffizienten des Gleichstromglieds mit seiner laufenden Summe. Für den Fall, dass der Mittelwert der Basis außerhalb eines Basisnormbereichs liegt, der Mittelwert des Effektivwerts über einem ersten Nennstromgrenzwert liegt, die Varianz des Effektivwerts oberhalb einer Mindestvarianz liegt und das Vorzeichen des Abtastwerts mit dem Vorzeichen der laufenden Summe der Abtastwerte und der laufenden Summe der Koeffizienten des Gleichstromglieds übereinstimmt, wird ein Sättigungssignal ausgegeben und ein erfindungsgemäßes Verfahren kann in den Zustand der Extrapolation 4 wechseln.

Sind die Bedingungen für die Ausgabe eines Sättigungssignals nicht erfüllt, aber liegt eine transiente Signaländerung weiterhin vor, so kann zurück in den Zustand des transienten Vorgangs 2 gewechselt werden. Wird auch keine transiente Signaländerung detektiert, so kann zurück in den Zustand keine Sättigung 1 gewechselt werden.

In einer bevorzugten Ausführungsform können die Rechenparameter bereits während des Zustands des transienten Vorgangs 2 bestimmt werden.

Im Zustand der Extrapolation 4 werden ab Ausgabe des Sättigungssignals aus vor dem Beginn der Sättigung abgelegten Modellparametern jene Modellparameter ausgewählt, deren Effektivwert innerhalb einer Nennvarianz vom gemittelten Effektivwert des jeweiligen Zeitschritts liegt und aus den ausgewählten, auf einen Zeitschritt bezogenen gemittelten Modellparametern ein ungesättigtes Extrapolationssignalmodell bestimmt, mit Hilfe dessen korrigierte Abtastwerte ausgegeben werden.

In einer besonders bevorzugten Ausführungsform können nur dann korrigierte Abtastwerte ausgegeben werden, wenn der berechnete Koeffizient des Gleichstromglieds des Extrapolationssignalmodells innerhalb eines Effektivnormbereichs liegt, der Effektivwert des Extrapolationssignalmodells größer als ein zweiter Nennstromgrenzwert ist, der korrigierte Abtastwerte größer oder gleich einem korrigierten Abtastgrenzwert ist und das Vorzeichen des korrigierten Abtastwerts dem Vorzeichen der laufenden Summe des Koeffizienten des Gleichstromglieds entspricht.

Aus dem Zustand der Extrapolation 4 kann wieder in den Zustand des transienten Vorgangs 2 gewechselt werden, sofern innerhalb einer Periode des ausgangseitigen Stromsignals keine Sättigung mehr detektiert wird.

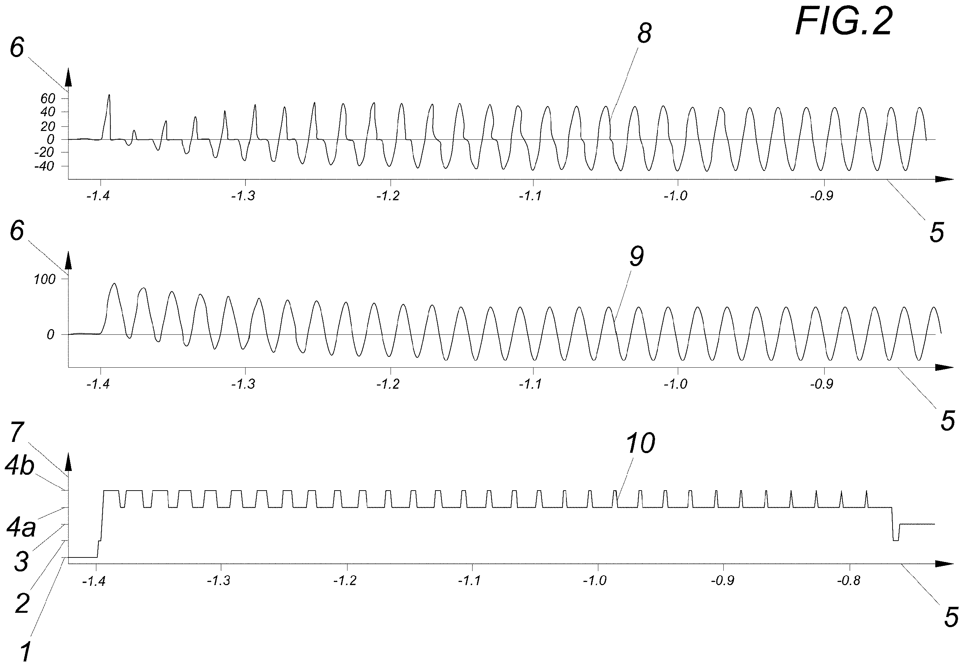

In der Fig. 2 ist in drei Diagrammen, die jeweils eine Zeitachse 5 in Sekunden und eine Wertachse 6 für die Stromstärke in Ampere sowie eine Wertachse 7 für den Zustand aufweisen, der zeitliche Verlauf einer Sättigung eines Stromwandlers dargestellt. Während die nicht korrigierten Abtastwerte 8 deutlich sättigungsbedingte Signalsprünge aufweisen, zeigen die korrigierten Abtastwerte 9 einen ungestörten sinusförmigen Stromverlauf. Der zeitliche Verlauf der Zustände 10 zeigt einen Wechsel zwischen dem Zustand keiner Sättigung 1, dem Zustand eines transienten Vorgangs 2, dem Zustand der Sättigungsdetektion 3 und dem Wechsel zwischen dem Zustand einer Extrapolation ohne Sättigung 4a und einer Extrapolation mit Sättigung 4b.

**Patentansprüche**

1.  Verfahren zur Sättigungsdetektion eines Stromwandlers wobei das gewandelte Stromsignal zeitdiskret abgetastet und von einer Recheneinheit der Abtastwert (8) je Zeitschritt in einem Messwertspeicher abgelegt, anhand mehrerer Abtastwerte (8) die Modellparameter eines ein Wechsel- und ein exponentielles Gleichstromglied aufweisenden Signalmodells bestimmt und die Modellparameter in einem Parameterspeicher abgelegt werden, **dadurch gekennzeichnet, dass** in aufeinanderfolgenden Zeitschritten als Rechenparameter eine laufende Summe der Abtastwerte (8), der Effektivwert des Wechselstromglieds mit seinem Mittelwert und seiner Varianz, die Basis des exponentiellen Gleichstromglieds mit seinem Mittelwert und der Koeffizient des Gleichstromglieds mit seiner laufenden Summe bestimmt und ein Sättigungssignal ausgegeben wird, wenn der Mittelwert der Basis außerhalb eines Basisnormbereichs liegt, der Mittelwert des Effektivwerts über einem ersten Nennstromgrenzwert liegt, die Varianz des Effektivwerts oberhalb einer Mindestvarianz liegt und das Vorzeichen des Abtastwerts (8) mit dem Vorzeichen der laufenden Summe der Abtastwerte (8) und der laufenden Summe der Koeffizienten des Gleichstromglieds übereinstimmt.

2.  Verfahren nach Anspruch 1, **dadurch gekennzeichnet, dass** die Abtastwerte (8) von der Recheneinheit auf eine transiente Signaländerung überwacht werden und die Modell- und Rechenparameter nur nach Eintritt einer transienten Signaländerung bestimmt werden.

3.  Verfahren nach Anspruch 1 oder 2, **dadurch gekennzeichnet, dass** ab Ausgabe des Sättigungssignals aus vor dem Beginn der Sättigung abgelegten Modellparametern jene Modellparameter ausgewählt werden, deren Effektivwert innerhalb einer Nennvarianz vom gemittelten Effektivwert des jeweiligen Zeitschritts liegt, von diesen Modellparametern der Mittelwert der Basis des Gleichstromglieds bestimmt und aus den ausgewählten, auf einen Zeitschritt bezogenen Modellparametern unter Verwendung des Mittelwerts der Basis des Gleichstromglieds ein ungesättigtes Extrapolationssignalmodell bestimmt wird, mit Hilfe dessen korrigierte Abtastwerte (9) ausgegeben werden.

4.  Verfahren nach Anspruch 3, **dadurch gekennzeichnet, dass** nur dann korrigierte Abtastwerte (9) ausgegeben werden, wenn der berechnete Koeffizient des Gleichstromglieds des Extrapolationssignalmodells innerhalb eines Effektivnormbereichs liegt, der Effektivwert des Extrapolationssignalmodells größer als ein zweiter Nennstromgrenzwert ist, der korrigierte Abtastwerte (9) größer oder gleich einem korrigierten Abtastgrenzwert ist und das Vorzeichen des korrigierten Abtastwerts (9) dem Vorzeichen der laufenden Summe des Koeffizienten des Gleichstromglieds entspricht.

5.  Verfahren nach Anspruch 3 oder 4, **dadurch gekennzeichnet, dass** eine vorgegebene Zeitspanne nach dem Vorzeichenwechsel des korrigierten Abtastwerts (9) das Sättigungssignal unterdrückt wird.

6.  Verfahren nach einem der Ansprüche 3 bis 5, wobei bei Ausgabe des Sättigungssignals die Normdifferenz aus dem korrigierten Abtastwert (9) und dem Abtastwert (8) bestimmt und für nachfolgende Zeitschritte aus dem betragsmäßigen Verhältnis aus der um die Normdifferenz erhöhten Differenz aus dem korrigierten Abtastwert (9) und dem Abtastwert (8) des Zeitschritts zum Mittelwert des Effektivwerts des Signalmodells eine Kenngröße ermittelt und das Sättigungssignal ausgegeben wird, wenn die Kenngröße eine Kenngrößenschwelle übersteigt.

7. Verfahren nach Anspruch 6, **dadurch gekennzeichnet, dass** bei einem Unterschreiten der Kenngröße unter die Kenngrößenschwelle die Normdifferenz aus dem korrigierten Abtastwert (9) und dem nicht korrigierten Abtastwert (8) des aktuellen Zeitschritts neu bestimmt wird.

**Claims**

1. Method for saturation detection of a current transformer, wherein the converted current signal is sampled discretely in time and the sampled value (8) per time step is stored by a computing unit in a measured value memory, the model parameters of a signal model having an alternating current element and an exponential direct current element are determined on the basis of a plurality of sampled values (8) and the model parameters are stored in a parameter memory, **characterised in that** a continuous sum of the sampled values (8), the effective value of the alternating current element with its mean value and its variance, the base of the exponential direct current element with its mean value and the coefficient of the direct current element with its continuous sum are determined as calculation parameter in successive time steps and a saturation signal is output if the mean value of the base lies outside a base normal range, the mean value of the effective value lies above a first nominal current limit value, the variance of the effective value lies above a minimum variance and the sign of the sampled value (8) coincides with the sign of the continuous sum of the sampled values (8) and the continuous sum of the coefficients of the direct current element.

2. Method according to claim 1, **characterised in that** the sampled values (8) are monitored by the computing unit for a transient signal change and the model and calculation parameters are only determined after the occurrence of a transient signal change.

3. Method according to claim 1 or 2, **characterised in that**, from the time of the output of the saturation signal, those model parameters whose effective value lies within a nominal variance of the averaged effective value of the respective time step are selected from model parameters stored before the start of saturation, the mean value of the base of the direct current element is determined from these model parameters and an unsaturated extrapolation signal model is determined from the selected model parameters related to a time step using the mean value of the base of the direct current element, with the aid of which corrected sampled values (9) are output.

4. Method according to claim 3, **characterised in that** corrected sampled values (9) are only output if the calculated coefficient of the direct current element of the extrapolation signal model lies within an effective normal range, the effective value of the extrapolation signal model is greater than a second nominal current limit value, the corrected sampled value (9) is greater than or equal to a corrected sampled limit value and the sign of the corrected sampled value (9) corresponds to the sign of the continuous sum of the coefficient of the direct current element.

5. Method according to claim 3 or 4, **characterised in that** the saturation signal is suppressed for a predetermined period of time after the sign change of the corrected sampled value (9).

6. Method according to one of claims 3 to 5, wherein, when the saturation signal is output, the normal difference is determined from the corrected sampled value (9) and the sampled value (8) and, for subsequent time steps, a characteristic value is determined from the absolute value-related ratio of the difference from the corrected sampled value (9) and the sampled value (8) of the time step, wherein the difference is increased by the normal difference, to the mean value of the effective value of the signal model, and the saturation signal is output if the characteristic value exceeds a characteristic value threshold.

7. Method according to claim 6, **characterised in that** if the characteristic value falls below the characteristic value threshold, the normal difference is redetermined from the corrected sampled value (9) and the uncorrected sampled value (8) of the current time step.

**Revendications**

1. Procédé de détection de saturation d'un transformateur de courant, dans lequel un signal de courant converti est échantillonné de façon discrète dans le temps et une valeur d'échantillonnage (8) par pas de temps est stockée par une unité de calcul dans une mémoire de valeurs de mesure, dans lequel les paramètres de modèle d'un modèle de signal présentant un membre de type courant alternatif et un membre de type courant continu exponentiel sont déterminés sur la base d'une pluralité de valeurs d'échantillonnage (8) et les paramètres de modèle sont stockés dans une mémoire pour paramètres, **caractérisé en ce qu'**une somme courante des valeurs d'échantillonnage (8), la valeur effective du membre de type courant alternatif avec sa valeur moyenne et sa variance, la base du membre de type courant continu exponentiel avec sa valeur moyenne et sa variance et le coefficient du membre de type courant continu avec sa somme courante sont déterminés en tant que paramètres de calcul par pas de temps successifs, et un signal de saturation est émis si la valeur moyenne de la base se situe à l'extérieur d'une plage standard de base, si la valeur moyenne de la valeur effective est supérieure à une première valeur limite de courant nominal, si la variance de la valeur effective se situe au-dessus d'une variance minimale et si le signe de la valeur d'échantillonnage (8) correspond au signe de la somme courante des valeurs d'échantillonnage (8) et de la somme courante des coefficients du membre de type courant continu.

2. Procédé selon la revendication 1, **caractérisé en ce que** les valeurs d'échantillonnage (8) sont surveillées par l'unité de calcul afin de détecter une variation transitoire du signal, et les paramètres du modèle et du calcul ne sont déterminés qu'après la survenance d'une variation transitoire du signal.

3. Procédé selon la revendication 1 ou 2, **caractérisé en ce qu'**à partir de la sortie du signal de saturation, les paramètres de modèle dont la valeur effective est comprise à l'intérieur d'une variance nominale de la valeur effective moyenne du pas de temps respectif sont sélectionnés parmi les paramètres de modèle stockés avant le début de la saturation, la valeur moyenne de la base du membre de type courant continu est déterminée à partir de ces paramètres de modèle, et un modèle de signal d'extrapolation non saturé est déterminé à partir des paramètres de modèle sélectionnés, rapportés à un pas de temps, en utilisant la valeur moyenne de la base du membre de type courant continu, à l'aide duquel des valeurs d'échantillonnage corrigées (9) sont émises.

4. Procédé selon la revendication 3, **caractérisé en ce que** des valeurs d'échantillonnage corrigées (9) ne sont émises que si le coefficient calculé du membre de type courant continu du modèle de signal d'extrapolation est compris à l'intérieur d'une plage de valeurs limites normales effectives, la valeur effective du modèle de signal d'extrapolation est supérieure à une deuxième valeur limite de courant nominale, la valeur d'échantillonnage corrigée (9) est supérieure ou égale à une valeur limite d'échantillonnage corrigée et le signe de la valeur d'échantillonnage corrigée (9) correspond au signe de la somme courante du coefficient du membre de type courant continu.

5. Procédé selon la revendication 3 ou 4, **caractérisé en ce que** le signal de saturation est supprimé pendant une période de temps prédéterminée après le changement de signe de la valeur d'échantillonnage corrigée (9),

6. Procédé selon l'une quelconque des revendications 3 à 5, dans lequel, lors de l'émission du signal de saturation, la différence normale entre la valeur d'échantillonnage corrigée (9) et la valeur d'échantillonnage (8) est déterminée, et, pour les pas de temps suivants, une valeur caractéristique est déterminée à partir du rapport quantitatif entre la différence entre la valeur d'échantillonnage corrigée (9) et la valeur d'échantillonnage (8) du pas de temps, augmentée de la différence normale, et la valeur moyenne de la valeur effective du modèle de signal, et le signal de saturation est émis lorsque la valeur caractéristique dépasse un seuil de valeur caractéristique.

7. Procédé selon la revendication 6, **caractérisé en ce que**, lorsque la valeur caractéristique chute en dessous du seuil de valeur caractéristique, la différence normale est déterminée à nouveau à partir de la valeur d'échantillonnage corrigée (9) et de la valeur d'échantillonnage non corrigée (8) du pas de temps actuel.

EP 4 253 969 B1

FIG.1

8

*FIG.2*

EP 4 253 969 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2008145694 A1
- EP 0882990 A2

- WO 03065533 A1